# EUROPÄISCHE PATENTSCHRIFT

(11) **EP 3 707 734 B1**
(45) Veröffentlichungstag und Bekanntmachung des Hinweises auf die Patenterteilung: **24.11.2021**
(21) Anmeldenummer: 18800078.0
(22) Anmeldetag: 06.11.2018
(51) Int. Cl.: H01F 7/16, H02K 33/02, G06F 3/01

(54) **ELEKTROMAGNET UND SCHALTBEDIENELEMENT MIT EINEM SOLCHEN ELEKTROMAGNETEN**
ELECTROMAGNET AND SWITCH-OPERATING ELEMENT COMPRISING SUCH AN ELECTROMAGNET
ÉLECTROAIMANT ET ÉLÉMENT DE COMMANDE COMPRENANT UN TEL ÉLECTROAIMANT

(30) Priorität: 08.11.2017 DE 102017010325
(43) Veröffentlichungstag der Anmeldung: 16.09.2020
(73) Patentinhaber: Marquardt GmbH, 78604 Rietheim-Weilheim (DE)
(72) Erfinder: NEUGART, Elmar, 78048 Villingen-Schwenningen (DE)
(74) Vertreter: Jostarndt Patentanwalts-AG
(86) Internationale Anmeldenummer: PCT/EP2018/080273
(87) Internationale Veröffentlichungsnummer: WO 2019/091954

(56) Entgegenhaltungen:
- WO-A1-2016/184728
- DE-A1-102011 018 639
- DE-A1-102011 103 169
- DE-A1-102014 018 634
- DE-A1-102015 009 313
- DE-U1- 9 014 763
- KR-A- 20110 051 422
- US-A1- 2008 106 223

## Beschreibung

Die Erfindung betrifft einen Elektromagneten nach dem Oberbegriff des Patentanspruchs 1.

Ein solcher Elektromagnet kann in einer Bedienanordnung, die insbesondere in einem Kraftfahrzeug angeordnet ist, Verwendung finden.

Ein derartiger Elektromagnet umfasst eine Spule und einen in der Spule axial, zwischen einer Ausgangsstellung und einer Bewegungsstellung bewegbaren Anker. Ein elastisches Element, das eine in axialer Richtung wirkende Kraft ausübt, wirkt mit dem Anker in axialer Richtung zusammen. Das elastische Element kann insbesondere zur Rückstellung des Ankers in die Ausgangsstellung vorgesehen sein. Bei Beaufschlagung der Spule mit elektrischer Spannung ist der Anker in und/oder gegen die Richtung der Kraft des elastischen Elements in die Bewegungsstellung bewegbar. Mit anderen Worten ist der Anker in Kraftrichtung des elastischen Elements bei einem "drückenden" Elektromagneten sowie gegen die Kraftrichtung des elastischen Elements bei einem "ziehenden" Elektromagneten bewegbar. Um ein Verklemmen des Ankers innerhalb eines gewissen Temperaturbereichs und damit eine Behinderung der Bewegung des Ankers zu vermeiden, ist der Anker mit einem Führungs- und/oder Lagerspiel in einer Führung der Spule gelagert. Es hat sich dabei herausgestellt, dass das Führungs- und/oder Lagerspiel zu einer Geräuscherzeugung bei Bewegung des Ankers führt, was in manchen Fällen als störend empfunden wird.

DE 10 2014 018634 A1 beschreibt ein axial vorgespannt gelagertes Bedienteil. KR 2011 0051422 A beschreibt einen zur Vermeidung von Geräuschen beidseitig axial vorgespannt und mit radial-seitlichem Kontakt federgelagerten lateral gleitenden Vibrationskörper.

Der Erfindung liegt die Aufgabe zugrunde, den Elektromagneten derart weiterzuentwickeln, dass die Geräuscherzeugung bei Bewegung des Ankers zumindest verringert ist.

Diese Aufgabe wird bei einem gattungsgemäßen Elektromagneten durch die kennzeichnenden Merkmale des Anspruchs 1 gelöst.

Beim ertindungsgemäßen Elektromagneten ist das elastische Element derart ausgestaltet, dass das elastische Element eine weitere Kraft in radialer Richtung auf den Anker ausübt. Aufgrund dieser radialen Kraft ist das Führungs- und/oder Lagerspiel auf das je nach vorliegender Temperatur erforderliche Maß reduziert. Mit anderen Worten wird der Anker durch die radial angreifende Kraft gegenüber der axialen Richtung verkippt, wobei die durch diese Verkippung bewirkte Vorspannung des Ankers dessen Führungs- und/oder Lagerspiel weitgehend eliminiert. Insbesondere ist das Führungs- und/oder Lagerspiel dabei soweit reduziert, dass ein Anschlagen des Ankers in der Führung der Spule bei Bewegung des Ankers weitgehend vermieden wird, so dass das ansonsten auftretende Anschlaggeräusch zumindest verringert ist. Weitere Ausgestaltungen der Erfindung sind Gegenstand der Unteransprüche.

Zweckmäßigerweise kann in der Spule eine Führungshülse als Führung für den Anker vorgesehen sein. Der Anker ist dann in der Führungshülse mit dem Führungs- und/oder Lagerspiel axial bewegbar gelagert. Des Weiteren kann der Elektromagnet derart ausgestaltet sein, dass der Anker bei Beaufschlagung der Spule mit elektrischer Spannung eine Druckkrall in die Richtung der Kraft des elastischen Elements ausübt. Es kann der Elektromagnet auch derart ausgestaltet sein, dass der Anker bei Beaufschlagung der Spule mit elektrischer Spannung eine Zugkraft gegen die Richtung der Kraft des elastischen Elements ausübt.

In einer besonders kompakten Ausgestaltung kann das elastische Element aus einer Feder, und zwar insbesondere aus einer Druckfeder, bestehen. Zweckmäßigerweise kann es sich bei dem elastischen Element um eine Schraubenfeder, die eine Anfangs- sowie eine Endwicklung umfasst, handeln. In einü1cher Art und Weise kann die Anfangswicklung gegenüber der Endwicklung exzentrisch versetzt angeordnet sein, derart dass aufgrund des exzentrischen Versatzes die radiale Kraft ausgeübt wird.

In einer einfachen sowie funktionssicheren Ausgestaltung kann am Anker ein Halteelement fur die Anfangs- und/oder für die Endwicklung der Schraubenfeder angeordnet sein. Das Halteelement kann eine exzentrisch zur Längsachse des Ankers versetzt angeordnete Aufnahme fur die Anfangs- und/oder fiir die Endwicklung aufweisen. Das Halteelement dient in diesem Fall als eine zur Magnetachse exzentrische Federaufnahme im Druckstück des Magneten, wobei die Federaufnahme den exzentrischen Versatz von der Anfangswicklung zur Endwicklung erzeugt.

Ein solcher Elektromagnet lässt sich in vorteilhafter Weise in einem Schaltbedienelement. das insbesondere tlir ein Kraftfahrzeug verwendbar ist, einsetzen. Ein solches Schaltbedienelement besitzt eine zur manuellen Einwirkung durch einen Benutzer vorgesehene Betätigungsfläche. Ein Sensor wirkt mit der Betätigungsfläche derart zusammen, dass der Sensor bei Einwirkung auf die Betätigungsfläche ein Signal erzeugt. Insbesondere dient dieses Signal zum Schalten und/oder Auslösen einer Funktion in der Art eines Schaltsignals. Weiterhin wirkt ein Aktor mit der Betätigungsfläche zusammen, derart dass die Betätigungsfläche zur Erzeugung einer für den Benutzer bei der Bedienung manuell fühlbaren Haptik mittels des Aktors bewegbar ist. Der Aktor besteht dabei aus einem erfindungsgemäß ausgestalteten Elektromagneten. In vorteilhafter Weise ist bei einem solchen Schaltbedienelement die ungewollte Geräuschentwicklung bei dessen manueller Bedienung durch den Benutzer zumindest reduziert beziehungsweise weitgehend eliminiert.

In zweckmäßiger weiterer Ausgestaltung des Schaltbedienelements kann am Halteelement ein Ansatz zur Zusammenwirkung mit der Betätigungsfläche vorgesehen sein. Der Ansatz kann in kompakter Art und Weise mittels des elastischen Elements kraftschlüssig an der Betätigungsfläche anliegen.

Für eine besonders bevorzugte Ausgestaltung des erfindungsgemäßen Elektromagneten ist nachfolgendes festzustellen.

Um in einem Bedienelement eine aktive haptische Rückmeldung zu erzeugen, kommt ein Hubmagnet zum Einsatz. Zwischen Anker und Führungshülse im Spulenkörper der Spule muss ein ausreichendes Lagerspiel vorhanden sein, damit über den vorgesehenen

Temperaturbereich, der beispielsweise in einem Kraftfahrzeug von -40°C bis zu + 110°C reicht, kein Klemmen des Ankers auftritt. Dieses Lagerspiel führt bei Aktivierung des Magneten zu einer störenden Geräuschbildung, da der Anker zuerst eine radiale und dann eine axiale Bewegung ausführt. Die Beschleunigung und/oder Verzögerung des Ankers in radialer Richtung, bei der das Lagerspiel zwischen Anker und Führungshülse des Spulenkörpers überbrückt wird, wodurch der Anker gegen die Führungshülse prallt, erzeugt ein Geräusch. Diese Geräuschbildung soll weitgehend vermieden werden.

Eine vorhandene Druckfeder, welche im Regelfall dazu dient den Anker in Achsrichtung in einer definielten Position zu halten, wenn der Magnet nicht aktiv ist, übt durch Versetzen der Anümgswicklung zur Endwicklung auch eine radiale Krall aus. Der exzentrische Versatz von Anfangswicklung zur Endwicklung kann beispielsweise durch eine zur Magnetachse exzentrische Federaufnahme im Druckstück des Magneten erzeugt werden. Der Anker wird durch diese radial angreifende Kraft verkippt und das Führungsspiel durch diese Vorspannung eliminiert. Geschaffen ist somit eine axiale, spielfreie Ankerbewegung in der Führungshülse eines Hubmagneten.

Die mit der Erfindung erzielten Vorteile bestehen insbesondere darin, dass übliche Maßnahmen, die ansonsten zur Geräuschdämmung für den Elektromagneten vorgesehen werden, wie beispielsweise
Fetten und/oder
das Lagerspielmittels teurer Materialpaarungen durch eingeschränkte Toleranzen zu verringern,
entfallen können. Dadurch werden wiederum die Teilekosten für den Elektromagneten reduziert.

Ein Ausführungsbeispiel der Erfindung mit verschiedenen Weiterbildungen und Ausgestaltungen ist in den Zeichnungen dargestellt und wird im folgenden näher beschrienen. Es zeigen
- Fig. I: ein Schaltbedienelement in schematischer Ansicht mit einem Elektromagneten als Aktor,
- Fig. 2: der Elektromagnet aus Fig. 1 in perspektivischer Darstellung,
- Fig. 3: ein Detail des Elektromagneten aus Fig. 2 in vergrößerter Darstellung und
- Fig. 4: einen Schnitt durch den Elektromagneten aus Fig. 2.

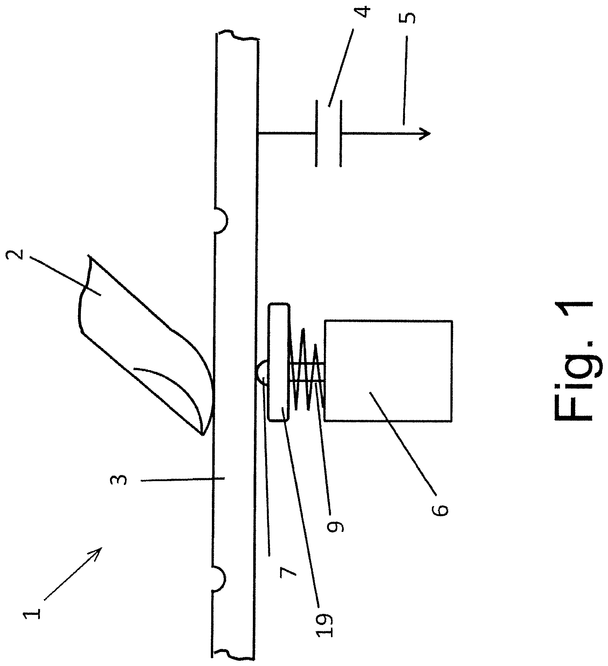

In Fig. 1 ist ein Schaltbedienelement 1, das beispielsweise in einem Bedienfeld im Almaturenbrett eines Kraftfahrzeugs befindlich ist, in schematischer Ansicht zu sehen. Das Schaltbedienelement 1 umfasst eine Betätigungsfläche 3, auf die der Benutzer beispielsweise mittels des Fingers 2 seiner Hand manuell einwirken kann. Mit der BetätigungsBäche 3 wirkt ein Sensor 4, bei dem es sich beispielsweise um einen kapazitiv arbeitenden Sensor 4 handelt, derart zusammen, dass der Sensor 4 bei Einwirkung des Fingers 2 auf die Betätigungsfläche 3 ein Signal 5 erzeugt. Das Signal 5 dient wiederum zum Schalten und/oder Auslösen einer Funktion in der Art eines Schaltsignals, beispielsweise lässt sich dadurch die Sitzheizung des Kranfahrzeugs einschalten. Mit der Betätigungsfläche 3 wirkt weiterhin ein Aktor 6 zusammen, derart dass die Betätigungsfläche 3 zur Erzeugung einer I·Iaptik für den Benutzer mittels des Aktm·s 6 bewegbar ist. Mit anderen Worten spürt der die Betätigungstläche 3 berührende Finger 2 des Benutzers die durch den Aktor 6 bewirkte Bewegung der Betätigungsfläche 3, was dem Benutzer beispielsweise die BetHtigung des Schaltbedienelements 1 signalisiert. Selbstverständlich kann anstelle des in Fig. 1 dargestellten kapazitiv arbeitendes Sensors 4 auch ein nach einem anderen Wirkprinzip arbeitender Sensor, beispielsweise ein induktiver Sensor, ein mechanischer Drucksensor o. dgl., verwendet werden.

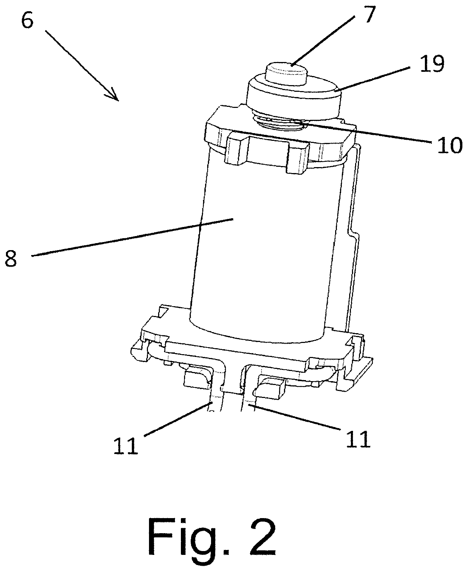

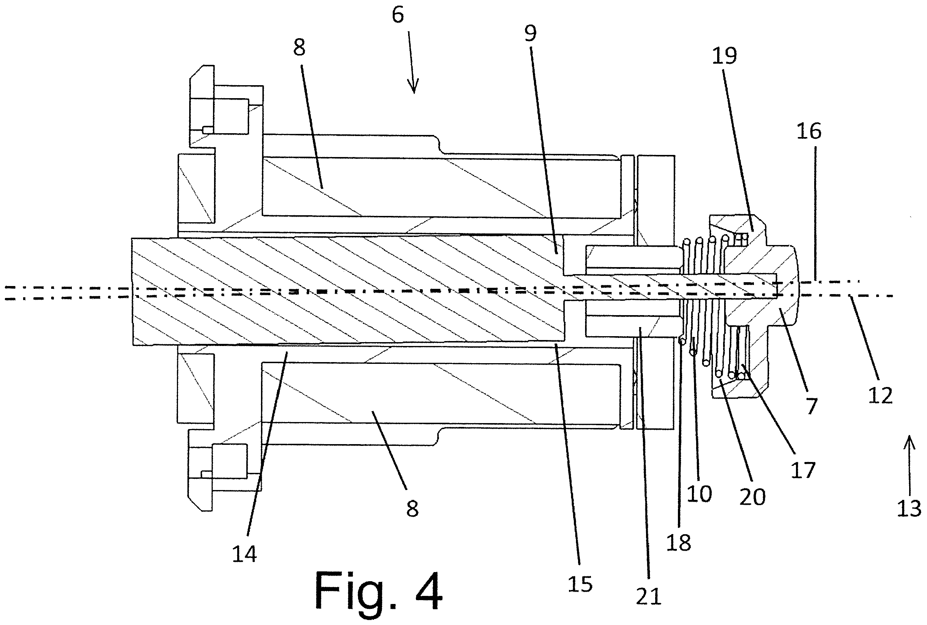

Der Aktor 6 besteht aus einem Elektromagneten, der mittels eines Ansatzes 7 auf die Betätigungstläche 3 zu deren Bewegung einwirkt. Der in Fig. 2 näher gezeigte Elektromagnet 6 umfasst eine Spule 8 und einen in einer Führungshülse 14 der Spule 8 in axialer Richtung 12 zwischen einer Ausgangs- sowie einer Bewegungsstellung bewegbaren Anker 9 (siehe auch Fig. 4). Des Weiteren ist ein mit dem Anker 9 zusammenwirkendes elastisches Element 10, das eine in axialer Richtung 12 wirkende Kraft ausübt, vorgesehen. Das elastische Element 10 dient insbesondere zur Rückstellung des Ankers 9 in die Ausgangsstellung. Bei Beaufschlagung der Spule 8 mit elektrischer Spannung über elektrische Zuleitungen 11 ist der Anker 9 in und/oder gegen die Richtung 12 der Kraft des elastischen Elements 10 von der Ausgangsstellung in die Bewegungsstellung bewegbar. In einer Ausgestaltung kann damit der Anker 9 bei Beaufschlagung der Spule 8 mit elektrischer Spannung eine Druckkraft in die Richtung 12 der Kraft des elastischen Elements 10 ausüben. In einer anderen Ausgestaltung kann somit der Anker 9 bei ßeaufschlagung der Spule 8 mit elektrischer Spannung eine Zugkraft gegen die Richtung 12 der Kraft des elastischen Elements 10 ausüben.

Wie näher in Fig. 4 zu sehen ist, ist der Anker 9 in der Führungshülse 14 mit einem Führungs- und/oder Lagerspiel 15 axial bewegbar gelageti. Das elastische Element 10 ist derart ausgestaltet, dass das elastische Element 10 eine weitere Kraft in radialer Richtung 13 auf den Anker 9 ausübt. Durch diese in radialer Richtung 13 angreifende Kraft wird der Anker 9 in der Führungshülse 14 geringfügig aus der axialen Richtung 12 in eine Schrägrichtung 16 verkippt Diese Verkippung gegenüber der axialen Richtung 12 durch die radiale Kraft bewirkt wiederum eine Vorspannung für den Anker 9, so dass das Führungs- und/oder Lagerspiel 15 in der Führungshülse 14 bei Bewegung des Ankers 9 reduziert beziehungsweise weitgehend eliminiert ist. Dadurch wird wiederum das Anschlagen des Ankers 9 an der Führungshülse 14 und/oder am Körper der Spule 8 bei dessen Bewegung weitgehend verhindert, so dass die Geräuscherzeugung bei der Bewegung des Ankers 9 zumindest reduziert ist.

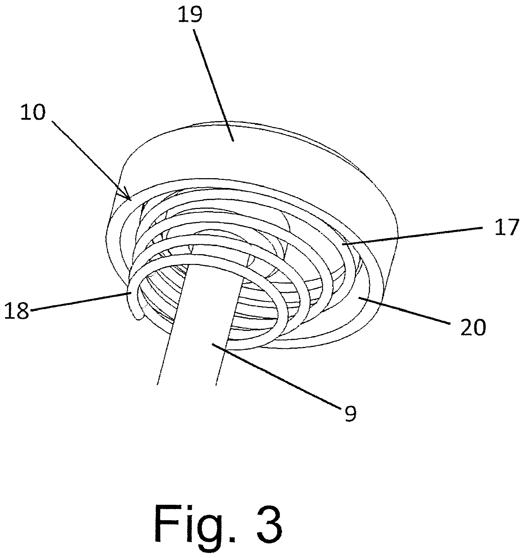

In bevorzugter Weise besteht das elastische Element 10 aus einer Feder, und zwar aus einer als Schraubenfeder ausgebildeten Druckfeder, wie in Fig. 3 gezeigt ist. Die Schraubenfeder 10 umfasst eine Anfangswicklung 17 sowie eine Endwicklung 18. Die Anfangswicklung 17 ist gegenüber der Endwicklung 18 exzentrisch versetzt angeordnet, derart dass aufgrund des exzentrischen Versatzes die in radialer Richtung 13 wirkende Kraft auf den Anker 9 ausgeübt wird.

Am Anker 9 ist ein Halteelement 19 für die Anfangswicklung 17 der Schraubenfeder 10 angeordnet Das Halteelement 19 weist eine exzentrisch zu der in axialer Richtung 12 verlaufenden Längsachse des Ankers 9 versetzt angeordnete Aufnahme 20 fur die Anfangswicklung 17 auf. Mit Hilfe dieser versetzt angeordneten Aufnahme 20 wird dann der exzentrische Versatz von der Anfangswicklung 17 zur Endwicklung 18 erzielt. Selbstverständlich kann auch umgekehrt eine exzentrische Aufnahme flir die Endwicklung 18 der Schraubenfeder 10 vorgesehen sein, was jedoch nicht weiter gezeigt ist.

Der mit der Betätigungsfläche 3 zusammenwirkende Ansatz 7 ist gemäß Fig. 4 gegenüberliegend zur Aufnahme 20 am Halteelement 19 angeordnet. Wie aus Fig. 1 und Fig. 4 ersichtlich ist, ist der Elektromagnet 6 derart an der Betätigungsfläche 3 orientiert, dass zwischen dem Anker 9 und einem an der Spule 8 bzw. am Elektromagneten 6 befindlichen Kern 21 ein zur Funktion notwendiger Luftspalt entsteht Durch das elastische Element 10 wird der Anker 9 über das in der Art eines Druckstücks wirkende Halteelement 19 kraftschlüssig und spielfrei an die Betätigungsfläche 3 gedrückt. Bei Beaufschlagung der Spule 8 mit elektrischer Spannung über die elektrischen Zuleitungen 11 und der daraus resultierenden magnetischen Kraft, wirkt diese magnetische Kraft zusätzlich zur Kraft des elastischen Elements 10 in axialer Richtung 12 gegen die Betätigungsfläche 3, um die Haptik für die Betätigungsfläche 3 zu erzeugen.

Die Erfindung ist nicht auf das beschriebene und dargestellte Ausführungsbeispiel beschränkt. Die Erfindung umfasst weiterhin auch alle fachmännischen Weiterbildungen im Rahmen der Patentansprüche. So kann die Erfindung nicht nur für ein Schaltbedienelement im Kraftfahrzeug, also als Bedienschalter oder als ein mehrere Bedienschalter umfassendes Schaltbedienfeld im Automotive-Bereich, sondern auch als Schaltbedienelement im Consumer-Bereich, beispielsweise in Hausgeräten, Waschmaschinen, Kaffeeautomaten, Audiogeräten, Videogeräten, Telekommunikationsgeräten, Elektrowerkzeugen o. dgl. Verwendung finden. Des Weiteren ist der erfindungsgemäße Elektromagnet vie!HHtig in Anwendungen einsetzbar, in denen eine präzise Führung des Ankers mit geringem Lagerspiel gewünscht ist.

### Bezugszeichen-Liste:

- 1:: Schaltbedienelement
- 2:: Finger (des Benutzers)
- 3:: Betätigungsfläche
- 4:: Sensor
- 5:: Signal
- 6:: Aktor / Elektromagnet
- 7:: Ansatz
- 8:: Spule (von Elektromagnet)
- 9:: Anker (von Elektromagnet)
- 10:: elastisches Element / Schraubenfeder
- 11:: (elektrische) Zuleitung (für Spule)
- 12:: axiale Richtung
- 13:: radiale Richtung
- 14:: Führungshülse (für Anker)
- 15:: Lagerspiel
- 16:: Schrägrichtung
- 17:: Anfangswicklung (von Schraubenfeder)
- 18:: Endwicklung (von Schraubenfeder)
- 19:: Halteelement (für Anfangswicklung)
- 20:: Aufnahme (an Halteelement)
- 21:: Kern (von Elektromagnet)

## Patentansprüche

1. Elektromagnet mit einer Spule (8), mit einem in der Spule (8) axial bewegbaren, mit einem Führungs- und/oder Lagerspiel (15) gelagerten Anker (9), und mit einem mit dem Anker (9) in axialer Richtung (12) zusammenwirkenden elastischen Element (I 0), das eine in axialer Richtung (12) wirkende Kraft, insbesondere zur Rückstellung des Ankers (9), ausübt, wobei der Anker (9) bei Beaufschlagung der Spule (8) mit elektrischer Spannung in und/oder gegen die Richtung (12) der Kraft des elastischen Elements (10) bewegbar ist, **dadurch gekennzeichnet, dass** das elastische Element (10) derart ausgestaltet ist, dass das elastische Element (10) eine weitere Kraft in radialer Richtung (13) auf den Anker (9) zur Verkippung des Ankers (9) gegenüber der axialen Richtung (12) ausübt, wobei das Führungs- und/oder Lagerspiel (15) durch die radiale Kraft reduziert ist, insbesondere eliminiert ist.

2. Elektromagnet nach Anspruch 1, **dadurch gekennzeichnet, dass** am Anker (9) ein Halteelement (19) für die Anfangs- und/oder für die Endwicklung (17, 18) des als Schraubenfeder ausgestalteten elastischen Elements (10) angeordnet ist, wobei der Elektromagnet eingerichtet ist zum Bereitstellen eines mit einer zur manuellen Einwirkung vorgesehenen Betätigungsfläche (3) zusammenwirkenden Aktuators (6).

3. Elektromagnet nach Anspruch 2, **dadurch gekennzeichnet, dass** die weitere Kraft in radialer Richtung über das Halteelement (19) auf den Anker (9) ausgeübt wird, wobei der Anker (9) durch die radial angreifende Kraft gegenüber der axialen Richtung derart verkippt wird, dass die durch diese Verkippung bewirkte Vorspannung des Ankers (9) dessen Führungs- und/oder Lagerspiel (15) weitgehend eliminiert.

4. Elektromagnet nach einem der vorhergehenden Ansprüche, **dadurch gekennzeichnet, dass** in der Spule (8) eine Führungshülse (14) vorgesehen ist, wobei der Anker (9) in der Führungshülse (14) mit dem Führungs- und/oder Lagerspiel (15) axial bewegbar gelagert ist.

5. Elektromagnet nach einem der vorhergehenden Ansprüche, **dadurch gekennzeichnet, dass** der Anker (9) bei Beaufschlagung der Spule (8) mit elektrischer Spannung eine Druckkraft in die Richtung (12) der Kraft des elastischen Elements (10) ausübt.

6. Elektromagnet nach einem der vorhergehenden Ansprüche, **dadurch gekennzeichnet, dass** der Anker (9) bei Beaufschlagung der Spule (8) mit elektrischer Spannung eine Zugkraft gegen die Richtung (12) der Kraft des elastischen Elements (10) ausübt.

7. Elektromagnet nach einem der vorhergehenden Ansprüche, **dadurch gekennzeichnet, dass** das elastische Element (10) aus einer Feder, insbesondere aus einer Druckfeder, besteht.

8. Elektromagnet nach einem der vorhergehenden Ansprüche, **dadurch gekennzeichnet, dass** es sich bei dem elastischen Element (10) um eine Schraubenfeder handelt, die eine Anfangswicklung (17) sowie eine Endwicklung (18) umfasst, und dass die Anfangswicklung (17) gegenüber der Endwicklung (18) exzentrisch versetzt angeordnet ist, derart dass aufgrund des exzentrischen Versatzes die radiale Kraft ausgeübt wird.

9. Elektromagnet nach Anspruch 8, **dadurch gekennzeichnet, dass** am Anker (9) ein Halteelement (19) für die Anfangs- und/oder für die Endwicklung (17, 18) der Schraubenfeder (10) angeordnet ist und dass das Halteelement (19) eine exzentrisch zur Längsachse des Ankers (9) versetzt angeordnete Aufnahme (20) für die Anfangs- und/oder für die Endwicklung (17, 18) aufweist.

10. Schaltbedienelement, insbesondere für ein Kraftfahrzeug, mit einer zur manuellen Einwirkung vorgesehenen Betätigungsfläche (3), mit einem mit der Betätigungsfläche (3) derart zusammenwirkenden Sensor (4), dass der Sensor (4) bei Einwirkung auf die Betätigungsfläche (3) ein Signal (5) erzeugt, wobei insbesondere das Signal (5) zum Schalten und/oder Auslösen einer Funktion in der Art eines Schaltsignals dient, und mit einem mit der Betätigungsfläche (3) zusammenwirkenden Aktor (6), derart dass die Betätigungsfläche (3) zur Erzeugung einer Haptik mittels des Aktors (6) bewegbar ist, **dadurch gekennzeichnet, dass** der Aktor (6) aus einem Elektromagneten nach einem der vorhergehenden Ansprüche besteht.

11. Schaltbedienelement nach Anspruch 10, **dadurch gekennzeichnet, dass** am Halteelement (19) ein Ansatz (7) zur Zusammenwirkung mit der Betätigungsfläche (3) vorgesehen ist, und dass vorzugsweise der Ansatz (7) mittels des elastischen Elements (10) kraftschlüssig an der Betätigungsfläche (3) anliegt.

## Claims

1. Electromagnet having a coil (8), having an armature (9) which can be moved axially in the coil (8) and is mounted with a guide and/or bearing clearance (15), and having an elastic element (I O) which interacts with the armature (9) in the axial direction (12) which exerts a force acting in the axial direction (12), in particular for resetting the armature (9), the armature (9) being movable in and/or against the direction (12) of the force of the elastic element (10) when electric voltage is applied to the coil (8) **characterized in that** the elastic element (10) is designed in such a way that the elastic element (10) exerts a further force in the radial direction (13) on the armature (9) for tilting the armature (9) with respect to the axial direction (12), the guide and/or bearing play (15) being reduced, in particular eliminated, by the radial force.

2. Electromagnet according to claim 1, **characterized in that** a holding element (19) for the initial and/or for the final winding (17, 18) of the elastic element (10) designed as a helical spring is arranged on the armature (9), the electromagnet being set up to provide an actuator (6) which interacts with an actuating surface (3) provided for manual action.

3. Electromagnet according to claim 2, **characterized in that** the further force is exerted on the armature (9) in the radial direction via the retaining element (19), the armature (9) being tilted relative to the axial direction by the radially acting force in such a way that the prestressing of the armature (9) caused by this tilting largely eliminates its guide and/or bearing play (15).

4. Electromagnet according to one of the aforementioned claims, **characterized in that** a guide sleeve (14) is provided in the coil (8), the armature (9) being mounted axially movably in the guide sleeve (14) with the guide and/or bearing clearance (15).

5. Electromagnet according to one of the preceding claims, **characterized in that** the armature (9) exerts a compressive force in the direction (12) of the force of the elastic element (10) when electrical voltage is applied to the coil (8).

6. Electromagnet according to any one of the preceding claims, **characterized in that** the armature (9) exerts a pulling force against the direction (12) of the force of the elastic element (10) when electric voltage is applied to the coil (8).

7. Electromagnet according to one of the preceding claims, **characterized in that** the elastic element (10) consists of a spring, in particular a compression spring.

8. Electromagnet according to any one of the preceding claims, **characterized in that** said elastic element (10) is a helical spring comprising an initial winding (17) and an end winding (18), and **in that** said initial winding (17) is eccentrically offset with respect to said end winding (18), such that said radial force is exerted due to said eccentric offset.

9. Electromagnet according to claim 8, **characterized in that** a holding element (19) for the initial winding and/or for the end winding (17, 18) of the helical spring (10) is arranged on the armature (9), and **in that** the holding element (19) has a receptacle (20) for the initial winding and/or for the end winding (17, 18), which receptacle is arranged offset eccentrically with respect to the longitudinal axis of the armature (9).

10. Switch control element, in particular for a motor vehicle, having an actuating surface (3) provided for manual action, having a sensor (4) which interacts with the actuating surface (3) in such a way that the sensor (4) generates a signal (5) when the actuating surface (3) is acted upon, wherein in particular the signal (5) serves for switching and/or triggering a function in the manner of a switching signal, and with an actuator (6) cooperating with the actuating surface (3) in such a way that the actuating surface (3) can be moved by means of the actuator (6) in order to produce a haptic, **characterised in that** the actuator (6) consists of an electromagnet according to one of the preceding claims.

11. Switch control element according to claim 10, **characterized in that** a projection (7) for interacting with the actuating surface (3) is provided on the retaining element (19), and **in that** preferably the projection (7) bears non-positively against the actuating surface (3) by means of the elastic element (10).

## Revendications

1. Electro-aimant avec une bobine (8), avec une armature (9) mobile axialement dans la bobine (8), qui est montée avec un jeu de guidage et/ou de palier (15), et avec un élément élastique (I O) qui coopère avec l'armature (9) dans la direction axiale (12), qui exerce une force agissant dans la direction axiale (12), en particulier pour le rappel de l'armature (9), l'armature (9) étant mobile dans et/ou contre la direction (12) de la force de l'élément élastique (10) lorsqu'une tension électrique est appliquée à la bobine (8), **caractérisé en ce que** l'élément élastique (10) est conçu de telle sorte que l'élément élastique (10) exerce une force supplémentaire dans la direction radiale (13) sur l'armature (9) pour faire basculer l'armature (9) par rapport à la direction axiale (12), le jeu de guidage et/ou de palier (15) étant réduit, en particulier éliminé, par la force radiale.

2. Electro-aimant selon la revendication 1, **caractérisé en ce qu'**un élément de maintien (19) pour l'enroulement initial et/ou pour l'enroulement final (17, 18) de l'élément élastique (10) conçu comme un ressort hélicoïdal est disposé sur l'armature (9), l'électroaimant étant configuré pour fournir un actionneur (6) coopérant avec une surface d'actionnement (3) prévue pour une action manuelle.

3. Electro-aimant selon la revendication 2, **caractérisé en ce que** la force supplémentaire est exercée sur l'induit (9) dans la direction radiale par l'intermédiaire de l'élément de retenue (19), l'induit (9) étant basculé par rapport à la direction axiale par la force agissant radialement de telle sorte que la précontrainte de l'induit (9) provoquée par ce basculement élimine en grande partie son jeu de guidage et/ou de palier (15).

4. Electro-aimant selon la première des revendications précédentes, **caractérisé en ce qu'**une douille de guidage (14) est prévue dans la bobine (8), l'armature (9) étant montée de manière mobile axialement dans la douille de guidage (14) avec le jeu de guidage et/ou de palier (15).

5. Electro-aimant selon l'une des revendications précédentes, **caractérisé en ce que** l'armature (9) exerce une force de compression dans la direction (12) de la force de l'élément élastique (10) lorsqu'une tension électrique est appliquée à la bobine (8).

6. Electro-aimant selon l'une des revendications précédentes, **caractérisé en ce que** l'armature (9) exerce une force de traction à l'encontre de la direction (12) de la force de l'élément élastique (10) lorsqu'une tension électrique est appliquée à la bobine (8).

7. Electro-aimant selon l'une des revendications précédentes, **caractérisé en ce que** l'élément élastique (10) est constitué par un ressort, notamment un ressort de compression.

8. Electro-aimant selon l'une quelconque des revendications précédentes, **caractérisé en ce que** l'élément élastique (10) est un ressort hélicoïdal comprenant un enroulement initial (17) et un enroulement final (18), et **en ce que** l'enroulement initial (17) est excentré par rapport à l'enroulement final (18) de sorte que la force radiale s'exerce du fait du décalage excentré.

9. Electro-aimant selon la revendication 8, **caractérisé en ce qu'**un élément de maintien (19) pour l'enroulement initial et/ou pour l'enroulement final (17, 18) du ressort hélicoïdal (10) est disposé sur l'armature (9), et **en ce que** l'élément de maintien (19) présente un logement (20) pour l'enroulement initial et/ou pour l'enroulement final (17, 18), qui est disposé de manière excentrée par rapport à l'axe longitudinal de l'armature (9).

10. Elément de commande de commutation, en particulier pour un véhicule automobile, avec une surface d'actionnement (3) prévue pour une action manuelle, avec un capteur (4) qui coopère avec la surface d'actionnement (3) de telle sorte que le capteur (4) génère un signal (5) lorsqu'il agit sur la surface d'actionnement (3), dans laquelle notamment le signal (5) sert à commuter et/ou à déclencher une fonction à la manière d'un signal de commutation, et avec un actionneur (6) coopérant avec la surface d'actionnement (3) de telle sorte que la surface d'actionnement (3) puisse être déplacée au moyen de l'actionneur (6) afin de produire une haptique, **caractérisé en ce que** l'actionneur (6) est constitué d'un électroaimant selon l'une des revendications précédentes.

11. Elément de commande de commutation selon la revendication 10, **caractérisé en ce qu'**une saillie (7) est prévue sur l'élément de retenue (19) pour coopérer avec la surface d'actionnement (3), et **en ce que** la saillie (7) s'appuie de préférence par adhérence sur la surface d'actionnement (3) au moyen de l'élément élastique (10).
